# EUROPEAN PATENT APPLICATION

(11) **EP 4 597 585 A1**
(43) Date of publication of application: **06.08.2025**
(21) Application number: 23905635.1
(22) Date of filing: 28.11.2023
(51) Int. Cl.: H01L 31/18, H01L 31/0224

(54) **SOLAR CELL WITH COPPER GRID LINE, AND PREPARATION METHOD THEREFOR**

(30) Priority: 22.12.2022 CN 202211658038
(71) Applicant: Tongwei Solar (Chengdu) Co., Ltd., Chengdu, Sichuan 610299 (CN)
(72) Inventor: JI, Ruikai, Chengdu, Sichuan 610299 (CN); ZHANG, Weiguan, Chengdu, Sichuan 610299 (CN); TAN, Shixiang, Chengdu, Sichuan 610299 (CN); LI, Xuefeng, Chengdu, Sichuan 610299 (CN)
(74) Representative: Gill Jennings & Every LLP
(86) International application number: PCT/CN2023/134570
(87) International publication number: WO 2024/131467

(57) **Abstract**

Provided in the embodiments of the present application are a solar cell with a copper grid line, and a preparation method therefor. The preparation method for a solar cell with a copper grid line comprises the following steps: plating a copper film on both a first face and a second face of a cell sheet to be subjected to grid line preparation; then, printing a photoresist on the surface of the copper film on the first face, wrapping edges of the cell sheet with an edge-wrapping adhesive, and then performing baking for the first time, so as to dry the edge-wrapping adhesive and the photoresist; then, printing the photoresist on the second face, and performing baking for the second time; and then performing an electroplating treatment, so as to form a copper grid line, and then performing a film removal treatment.

## Description

This application claims priority to Chinese patent application No. 202211658038.9, entitled "SOLAR CELL WITH COPPER GRID LINE AND PREPARATION METHOD THEREFOR" filed with the China National Intellectual Property Administration on December 22, 2022, the content of which is hereby incorporated by reference in its entirety.

### TECHNICAL FIELD

The present application relates to the field of new energy, particularly to a solar cell with copper gridlines and a preparation method thereof.

### BACKGROUND

Compared with passivated emitter and rear (PERC) cells, heterojunction cells exhibit higher cell efficiency, but consume more silver, which leads to increased costs of the heterojunction cells.

The electric conductivity of a copper wire at 20°C is 1.72×10⁸ Ω·m, while the electric conductivity of a silver wire at 20°C is 1.59×10⁸ Ω·m, and thus the electric conductivities of the two are similar. Under the same condition, by using copper to prepare electrode gridlines of the cells, it neither has a significant impact on the series resistance (Rs) of the cell sheets due to an excessive change in the electrode resistance, nor it has an impact on the short-circuit current (Jsc) and conversion efficiency of the cell sheets. Therefore, in order to reduce costs and increase efficiency, copper can replace silver to be utilized as a material for the electrode gridlines. However, the copper gridlines cannot be directly coated and formed onto the surface of silicon wafer by printing. At present, when preparing solar cells with copper gridlines, the copper gridlines are usually be formed on the surface of silicon wafer by a process of coating film-photolithography-electroplating-resist stripping and etching.

However, in the current process, it is necessary to bake the silicon wafer at least three times in the photolithography process, which leads to a relatively long preparation time period for the copper gridlines, unfavorable for improving the production efficiency of the solar cells.

### SUMMARY

According to embodiments of the present application, a solar cell with copper gridlines and a preparation method thereof are provided.

According to a first aspect, an embodiment of the present application provides a method for preparing a solar cell with copper gridlines, which includes the following steps:
plating copper films on a first surface and a second surface of a cell sheet to be prepared with copper gridlines, respectively;
printing a photoresist on a surface of the copper film on the first surface;
wrapping edges of the cell sheet with an edge-wrapping adhesive;
performing a first baking to dry the edge-wrapping adhesive and the photoresist;
printing the photoresist on a surface of the copper film on the second surface, followed by a second baking;
performing an electroplating treatment to form the copper gridlines; and
performing a film removal process.

In an optional embodiment of the present application, a temperature of the first baking is equal to a temperature of the second baking, and a time period of the first baking is longer than a time period of the second baking.

During the first baking, both the photoresist and the edge-wrapping adhesive are required to be fully cured, and thus the time period of the first baking is longer than that of the first baking.

In an optional embodiment of the present application, the time period of the first baking is in a range from 7 minutes to 15 minutes, and the temperature of the first baking is in a range from 60°C to 100°C.

In an optional embodiment of the present application, the time period of the second baking is in a range from 7 minutes to 15 minutes, and the temperature of the second baking is in a range from 60°C to 100°C.

In an optional embodiment of the present application, the copper film is plated by a PVD process.

In an optional embodiment of the present application, a region of the copper film printed with the photoresist is a printed region, and a distance from an edge of the printed region to a side edge of the cell sheet is in a range from 0.1 mm to 0.3 mm.

In an optional embodiment of the present application, the method for preparing the solar cell with copper gridlines further includes the following steps: exposing a region of the dried photoresist corresponding to the copper gridlines to light to form an exposed region corresponding to a copper gridline pattern on the photoresist; and then performing electroplating to form copper gridlines in the exposed region.

In an optional embodiment of the present application, the film removal process includes the following step: removing portions of the copper film and the photoresist that do not correspond to the copper gridlines.

By removing the portions of the copper film and the photoresist that do not correspond to the copper gridlines, only the copper seed layer in the exposed region is retained among the entire copper seed layer, and consequently the copper gridlines are retained, i.e., the copper gridlines are formed on the surface of the cell sheet.

In an optional embodiment of the present application, a thickness of the cell sheet is in a range from 0.12 mm to 0.14 mm.

In an optional embodiment of the present application, a thickness of the copper film is in a range from 135 nm to 155 nm.

In an optional embodiment of the present application, the step of wrapping edges of the cell sheet with the edge-wrapping adhesive includes: wrapping adhesive by using an adhesive-wrapping roller.

The adhesive-wrapping roller has a three-layer roller structure rotating coaxially with large upper and lower rollers and a small middle roller, surfaces of the three rollers jointly define a groove, and a hole is formed on a side surface of the groove to discharge the adhesive.

In an optional embodiment of the present application, in the three-layer roller structure, adjacent layers are sealed from each other.

In an optional embodiment of the present application, the upper roller and the middle roller are hollow to store the adhesive.

In an optional embodiment of the present application, the cell sheet includes a doped silicon wafer with a PN junction, and transparent conducting films located on the first surface and the second surface.

In an optional embodiment of the present application, the transparent conducting film is made of ITO.

In an optional embodiment of the present application, the first surface is a front surface of the cell sheet, and the second surface is a back surface of the cell sheet.

In an optional embodiment of the present application, the first surface is a back surface of the cell sheet, and the second surface is a front surface of the cell sheet.

According to a second aspect, an embodiment of the present application provides a solar cell with copper gridlines prepared with the method for preparing the solar cell with copper gridlines in any of the above-described embodiments.

### BRIEF DESCRIPTION OF THE DRAWINGS

To illustrate the technical solutions in the embodiments of the present application more clearly, the drawings used in the embodiments of the present application will be described briefly. It should be understood that the following drawing is merely for some embodiments of the present application and is not to be construed as limiting the scope. Other drawings can be derived according to the drawing by those of ordinary skill in the art without any creative effort.

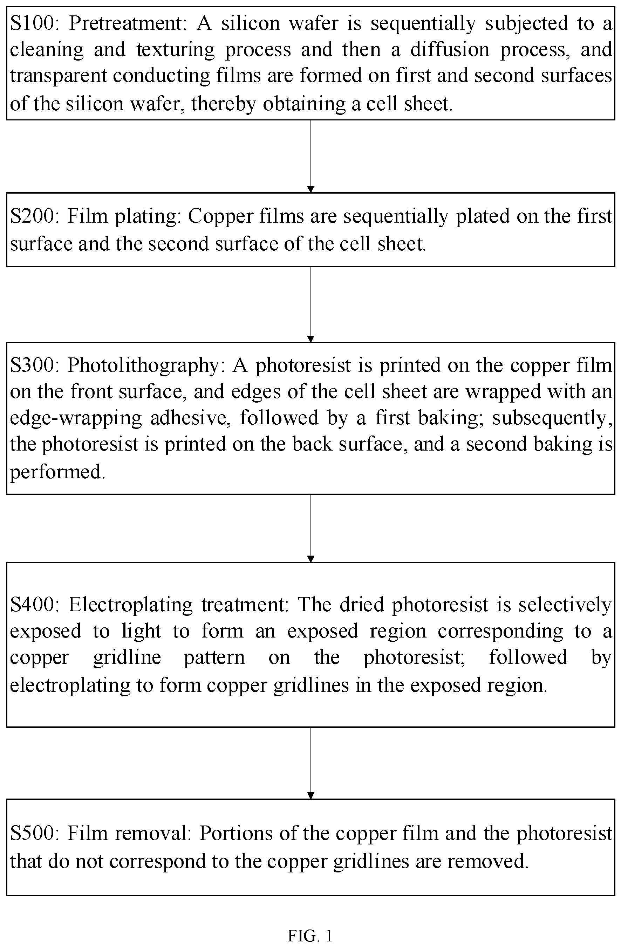

FIG. 1 shows a flow chart of a method for preparing a solar cell with copper gridlines according to an embodiment of the present application.

### DETAILED DESCRIPTION

Embodiments of technical solutions of the present application will now be described in detail with reference to the accompanying drawings. The following embodiments are only for illustrating the technical solutions of the present application more clearly, therefore only used as examples, but they should not be construed as limiting the protection scope of the present application.

Unless otherwise defined, all technical and scientific terms used herein have the same meaning as commonly understood by those of ordinary skill in the art to which the present application pertains. The terms used in the present application herein are for the purpose of describing embodiments only and are not intended to limit the present application. The terms "include" and "have" and any variations thereof in the specification and the above description of drawings of the present application are intended to cover non-exclusive inclusions. Specific conditions that are not specified in the examples refer to conventional conditions or can be in accordance with conditions suggested by manufacturers. Reagents or instruments without indication of manufacturer are conventional products that are commercially available.

In the process of preparing the solar cell with copper gridlines, a photoresist and an edge-wrapping adhesive are utilized. The photoresist can change its property under the condition of exposure to light. After the change, the photoresist can react with a developer to form an exposed region, which is beneficial for subsequent growth of copper gridlines. The edge-wrapping adhesive can wrap the side edges of the cell to prevent the breakage of the gridlines. By wrapping the edges of the cell with the edge-wrapping adhesive, the gridlines adjacent to the edges of the cell are not prone to fall off during the subsequent formation of the gridlines, thereby improving both yield and efficiency of the cell.

In conventional techniques for preparing the solar cell with copper gridlines, the edges of the cell sheet are usually wrapped with the edge-wrapping adhesive, followed by a first baking to cure the edge-wrapping adhesive. Subsequently, a photoresist is printed on one side of the cell sheet, and a second baking is performed to cure the printed photoresist. After that, the cell sheet is turned over, the photoresist is printed on the other side of the cell sheet, and then a third baking is performed. Throughout the entire process, the silicon wafer needs to be baked at least three times, which leads to a long preparation time for the copper gridlines, unfavorable for improving the production efficiency of the solar cells.

Therefore, an embodiment of the present application provides a method for preparing a solar cell with copper gridlines, which can shorten the preparation time of the gridlines and is beneficial to improving the production efficiency of the solar cell with copper gridlines.

The inventors have discovered that during preparing the copper gridlines, the compositions of the photoresist and the edge-wrapping adhesive are nearly the same, with the difference in that the photoresist further includes a photosensitive component. The acid-base polarity of the photoresist can be altered under exposure to light such as ultraviolet light. When the two materials are in the same condition, they neither react nor interfere with each other, and their curing time periods are not significantly different. Consequently, in the embodiments of the present application, during the preparation of the solar cell with copper gridlines, the photoresist and the edge-wrapping adhesive are cured at the same time to simplify the process steps. Hereinafter, a solar cell with copper gridlines and a preparation method thereof according to embodiments of the present application will be specifically described.

FIG. 1 shows a flow chart of a method for preparing a solar cell with copper gridlines according to an embodiment of the present application. The specific preparation method is as follows.

S100: Pretreatment: A silicon wafer is sequentially subjected to a cleaning and texturing process and then a diffusion process, and transparent conducting films are formed on first and second surfaces of the silicon wafer, thereby obtaining a cell sheet.

The first surface is a front surface of the cell sheet, and the second surface is a back surface of the cell sheet. Alternatively, the first surface is the back surface of the cell, and the second surface is the front surface of the cell.

The cleaning and texturing process is to remove impurities on the surface of the silicon wafer, and form textured pyramids on the surface of the silicon wafer, thereby reducing the reflectivity of the light on the surface of the silicon wafer and improving the absorbance of the cell. When cleaning and texturing, an alkaline solution, SC1 cleaning solution (i.e., a mixture solution of ammonia, hydrogen peroxide, and water), SC2 cleaning solution (i.e., a mixture solution of hydrochloric acid, hydrogen peroxide, and water), etc. are generally used for cleaning.

The diffusion process is to convert the silicon wafer into a doped P-type or N-type silicon wafer, and the doped silicon wafer contains a PN junction. The optical energy can be converted into electric energy through the internal PN junction. In the diffusion process, the silicon wafer is generally placed in a tube furnace, and then a phosphorus source or a boron source is introduced to form the doped silicon wafer. When the phosphorus source is introduced, the N-type silicon wafer can be formed. When the boron source is introduced, the P-type silicon wafer can be formed. Moreover, when the boron source is introduced, the temperature in the tube furnace is higher than that when the phosphorus source is introduced.

The transparent conducting film on the surface of the doped silicon wafer exhibits good electrical conductivity and can serve as a part of an electrode. The transparent conducting film is generally made of a conductive oxide such as indium tin oxide (ITO), with a thickness generally ranging from 135 nm to 155 nm. The transparent conducting film can usually be prepared by using a physical vapor deposition (PVD) device to accurately control its thickness. The doped silicon wafer with the PN junction and the transparent conducting films on the first and second surfaces thereof are collectively referred to as the cell sheet. There are no gridlines on its surface, and the thickness of the entire cell sheet is generally in the range from 0.12 mm to 0.14 mm.

S200: Film plating process: Copper films are sequentially plated on the first surface and the second surface of the cell sheet.

When film plating, the film layer is generally prepared by using a PVD device to accurately control the thickness of the copper film.

The copper film can not only provide a substrate for the subsequent growth of the copper gridlines but also plays a protective role to prevent damage to the surface of the cell sheet during the subsequent generation of the copper gridlines. The thickness thereof is generally in the range from 135 nm to 155 nm. Maintaining the thickness of the copper film within a suitable range can not only protect the cell sheet but also can ensure the photoelectric conversion performance of a finished cell product to be not affected when subsequently making the finished cell product.

In the present embodiment, when the copper film is plated, argon gas is ionized under a high vacuum condition, the argon ions are accelerated by an electromagnetic field and bombard the copper target with extremely high energy, the copper particles on the surface of the copper target escape from the original crystal lattice, and the sputtered particles are deposited onto the adjacent cell sheet to form the copper film.

S300: Photolithography process: A photoresist is printed on the copper film on the first surface, where a region of the copper film printed with the photoresist is referred to as a printed region, and edges of the cell sheet are wrapped with an edge-wrapping adhesive, followed by performing a first baking. Subsequently, the photoresist is printed on the second surface, and a second baking is performed.

During the first baking, the photoresist and the edge-wrapping adhesive can be dried simultaneously, without drying the photoresist and the edge-wrapping adhesive multiple times. This reduces the preparation time of the copper gridlines, favorable for improving the production efficiency of the solar cell with copper gridlines. Moreover, during the first baking, both the photoresist and the edge-wrapping adhesive are required to be fully cured to better ensure the curing effect. Thus, the time of the first baking is longer than that of the second baking under a condition that the first baking and the second baking have the same temperature. The time period of the first baking is in a range from 7 minutes to 15 minutes, and the time period of the second baking is in a range from 7 minutes to 15 minutes. The temperatures of the first baking and the second baking are generally controlled to be in a range from 60°C to 100°C.

It should be noted that, in the present embodiments, the "edges of the cell sheet" includes both the side surfaces of the cell sheet and the edge portions of the first surface and the second surface of the cell sheet. In the present embodiments, a distance from an edge of the printed region to a side edge of the cell sheet, which is also referred to as an edge-wrapping width, is generally in a range from 0.1 mm to 0.3 mm. Setting the printed region within a reasonable range can not only reduce the probability of gridline breakage of the copper gridlines, but also fully collect the carriers generated in the cell sheet, without affecting the photoelectric conversion efficiency of the finished cell.

The step of wrapping edges of the cell sheet with the edge-wrapping adhesive includes wrapping adhesive by using an adhesive-wrapping roller. The adhesive-wrapping roller is a device with a three-layer roller structure rotating coaxially with large upper and lower rollers and a small middle roller. Surfaces of the three rollers jointly define a groove, and a hole is formed on a side surface of the groove to discharge the adhesive. Adjacent layers are sealed from each other. The upper roller and the middle roller are hollow to store the adhesive. The adhesive is injected from the top into the upper roller. The edge-wrapping adhesive is distributed in the entire groove through gravity action and rotation. The cell sheet slides in the groove to wrap the edges of the cell sheet with the adhesive.

S400: Electroplating treatment: A region of the dried photoresist corresponding to the copper gridlines is exposed to light (this step is generally referred to as selective exposure) to form an exposed region corresponding to a copper gridline pattern on the photoresist; followed by electroplating to form copper gridlines in the exposed region.

During electroplating, the cell sheet is placed in an electroplating solution containing copper ions, and then an electrical current is applied, thereby generating copper gridlines on the exposed region. The electroplating is a conventionally used technique, and will not be described in detail herein.

S500: Film removal process: Portions of the copper film and the photoresist that do not correspond to the copper gridlines are removed.

As such, only the copper seed layer in the exposed region can be retained among the entire copper seed layer, and consequently the copper gridlines are retained, i.e., the copper gridlines are formed on the surface of the cell sheet.

Since the compositions of the photoresist and the edge-wrapping adhesive are nearly the same, with the difference in that the edge-wrapping adhesive does not include a photosensitive component, and thus its acid-base polarity cannot be altered under exposure to ultraviolet light. When baking the photoresist and the edge-wrapping adhesive simultaneously, they neither react nor interfere with each other. Moreover, their curing time periods are not significantly different. Consequently, compared to existing methods requiring baking twice to dry the photoresist and the edge-wrapping adhesive respectively, in the embodiments of the present application, the photoresist and the edge-wrapping adhesive can be dried by only one baking, which can reduce the preparation time of the copper gridlines, and is beneficial to improving the production efficiency of the solar cell with copper gridlines.

The features and performance of the present application are further described in detail below with reference to examples.

### Example 1

This example provides a solar cell with copper gridlines, which includes a cell sheet and the copper gridlines on the front and back surfaces of the cell sheet. The preparation method thereof is as follows.
(1) Pretreatment: The silicon wafer was cleaned and textured with an alkaline solution, SC1 cleaning solution and SC2 cleaning solution in sequence to enable the surface of the silicon wafer to form a pyramid-shaped textured structure. Next, the silicon wafer was placed in a tube furnace and was subjected to a diffusion process with a phosphorus source as a raw material to form an N-type silicon wafer. Subsequently, the N-type silicon wafer was placed in a PVD device, and then was plated with an ITO layer with a thickness of 145 nm on the front and back of the N-type silicon wafer respectively, forming a cell sheet with a thickness of 0.13 mm.
(2) Film plating process: Using a PVD device, argon gas was ionized under a high vacuum condition to bombard a copper target, and the copper particles sputtered from the copper target were deposited on the front and back surfaces of the adjacent cell sheet, respectively, to form a copper film with a thickness of 145 nm.
(3) Photolithography process: A photoresist was printed on the front surface of the cell sheet, and edges of the cell sheet were wrapped with an edge-wrapping adhesive, followed by performing a first baking to cure the edge-wrapping adhesive and the photoresist, where the first baking was performed at a temperature of 80°C for 8 minutes. After the first baking, the cell sheet was flipped, and the photoresist was printed on the back surface, followed by performing a second baking, where the second baking was performed at a temperature of 80°C for 8 minutes.
(4) Electroplating treatment: The photoresist on the front and back surfaces was subjected to selective exposure respectively to form exposure regions on the front and back surfaces. Subsequently, the cell sheet was placed in an electroplating solution containing copper ions, and an electrical current was applied to form copper gridlines on the exposed regions.
(5) Film removal process: The portions of the copper film and the photoresist that do not correspond to the copper gridlines were removed.

### Example 2

This example provides a solar cell with copper gridlines, which includes a cell sheet and the copper gridlines on the front and back surfaces of the cell sheet. Compared to Example 1, the main differences in this preparation method thereof are as follows.

In step (3), the first baking was performed at a temperature of 70°C for 10 minutes, and the second baking was performed at a temperature of 70°C for 8 minutes.

### Example 3

This example provides a solar cell with copper gridlines, which includes a cell sheet and the copper gridlines on the front and back surfaces of the cell sheet. Compared to Example 1, the main differences in this preparation method thereof are as follows.

In step (3), the first baking was performed at a temperature of 100°C for 7 minutes, and the second baking was performed at a temperature of 100°C for 9 minutes.

### Comparative Example 1

This comparative example provides a solar cell with copper gridlines, which includes a cell sheet and the copper gridlines on the front and back surfaces of the cell sheet. Compared to Example 1, the main differences in this preparation method thereof are as follows.

In step (3) of photolithography process: Firstly, edges of the cell sheet were wrapped with an edge-wrapping adhesive, followed by performing a first baking to cure the edge-wrapping adhesive, where the first baking was performed at a temperature of 80°C for 8 minutes. Then, the photoresist was printed on the front surface of the cell sheet, followed by performing a second baking to cure the photoresist, where the second baking was performed at a temperature of 80°C for 8 minutes. Subsequently, the photoresist was printed on the back surface of the cell sheet, followed by performing a third baking to cure the photoresist, where the third baking was performed at a temperature of 80°C for 8 minutes.

### Application Examples

Two groups of solar cells with copper gridlines were obtained by the methods in Example 1 and Comparative Example 1, respectively. The number of the solar cells with copper gridlines is 10 in each group, which are numbered from 1 to 10. The performance of the two groups of solar cells with copper gridlines were tested respectively.

### Weight aspect

The weight of the cell sheets, and the weight of the cell sheets printed with edge-wrapping adhesive and photoresist were measured by using an electronic balance, respectively. The specific results are shown in Table 1.

**Table 1 Weight changes of cell sheets in Example 1 and Comparative Example 1**

| Group | No. | Edge-wrapping width (µm) | Weight gain after coating and drying front surface (mg) | Weight gain after coating and drying back surface (mg) |
|---|---|---|---|---|
| Comparative Example 1 | 1 | 209 | 341 | 347 |
| | 2 | 192 | 356 | 350 |
| | 3 | 202 | 341 | 351 |
| | 4 | 204 | 349 | 337 |
| | 5 | 207 | 354 | 355 |
| | 6 | 194 | 338 | 332 |
| | 7 | 202 | 354 | 351 |
| | 8 | 201 | 365 | 358 |
| | 9 | 193 | 342 | 360 |
| | 10 | 206 | 339 | 350 |
| | Average | 201 | 347.9 | 349.1 |
| Example 1 | 1 | 209 | 348 | 338 |
| | 2 | 197 | 347 | 336 |
| | 3 | 210 | 344 | 351 |
| | 4 | 196 | 350 | 356 |
| | 5 | 193 | 341 | 361 |
| | 6 | 196 | 339 | 343 |
| | 7 | 195 | 343 | 345 |
| | 8 | 196 | 349 | 367 |
| | 9 | 194 | 361 | 362 |
| | 10 | 199 | 359 | 333 |
| | Average | 198.5 | 348.1 | 349.2 |

As can be seen from the above table, when the solar cell with copper gridlines is prepared by the preparation method in the example of the present application, there is little impact on the adhesive-wrapped width of the cell, the weight gain after coating and drying the front surface, and the weight gain after coating and drying the back surface. Therefore, the parameters can be controlled within the required ranges.

### Electrical performance

The electrical performance of each solar cell with copper gridlines in the two groups was tested separately by using a Halm tester. The test results are shown in Table 2.

**Table 2 Electrical performance of solar cells with copper gridlines in Example 1 and Comparative Example 1**

| Group | Sample | Short-circuit current (A) | Open-circuit voltage (V) | Series resistance (Ω) | Parallel resistance (Ω) | Leakage current (A) | Fill factor (%) | Conversion efficiency (%) |
|---|---|---|---|---|---|---|---|---|
| Comparative Example 1 | 1 | 8.4450 | 0.7467 | 2.6680 | 1462.7380 | 0.0025 | 83.0715 | 23.7590 |
| | 2 | 8.4556 | 0.7462 | 2.6713 | 1096.7557 | 0.0029 | 83.0087 | 23.7563 |
| | 3 | 8.4412 | 0.7468 | 2.6786 | 1321.0707 | 0.0028 | 83.0401 | 23.7442 |
| | 4 | 8.4568 | 0.7468 | 2.6709 | 1278.5264 | 0.0030 | 82.9141 | 23.7515 |
| | 5 | 8.4636 | 0.7467 | 2.7594 | 2411.3167 | 0.0027 | 82.8547 | 23.7503 |
| | 6 | 8.4693 | 0.7472 | 2.8117 | 2615.1828 | 0.0032 | 82.7443 | 23.7511 |
| | 7 | 8.4594 | 0.7471 | 2.7667 | 1822.2466 | 0.0026 | 82.8835 | 23.7590 |
| | 8 | 8.4537 | 0.7466 | 2.6566 | 1845.5799 | 0.0066 | 82.9269 | 23.7404 |
| | 9 | 8.4610 | 0.7467 | 2.6646 | 1251.6466 | 0.0027 | 82.8912 | 23.7523 |
| | 10 | 8.4526 | 0.7470 | 2.6401 | 1298.2019 | 0.0027 | 82.9355 | 23.7510 |
| | Average | 8.4558 | 0.7468 | 2.6988 | 1640.3265 | 0.0032 | 82.9271 | 23.7515 |
| Example 1 | 1 | 8.4571 | 0.7474 | 2.6721 | 1293.8494 | 0.0025 | 82.8694 | 23.7573 |
| | 2 | 8.4603 | 0.7462 | 2.6850 | 1372.9519 | 0.0053 | 82.9306 | 23.7469 |
| | 3 | 8.4413 | 0.7476 | 2.6488 | 964.5291 | 0.0030 | 82.9961 | 23.7573 |
| | 4 | 8.4311 | 0.7473 | 2.6705 | 3040.4546 | 0.0026 | 83.1093 | 23.7507 |
| | 5 | 8.4378 | 0.7474 | 2.6906 | 1334.3181 | 0.0027 | 83.0234 | 23.7480 |
| | 6 | 8.4259 | 0.7474 | 2.6986 | 2683.9487 | 0.0053 | 83.1282 | 23.7438 |
| | 7 | 8.4398 | 0.7477 | 2.7161 | 1417.2400 | 0.0026 | 82.9568 | 23.7448 |
| | 8 | 8.4501 | 0.7478 | 2.7185 | 1665.0060 | 0.0025 | 82.9010 | 23.7589 |
| | 9 | 8.4636 | 0.7479 | 2.7624 | 1890.1018 | 0.0033 | 82.7405 | 23.7532 |
| | 10 | 8.4350 | 0.7476 | 2.6680 | 1252.5706 | 0.0030 | 83.0731 | 23.7597 |
| | Average | 8.4442 | 0.7474 | 2.6931 | 1691.4970 | 0.0033 | 82.9729 | 23.7521 |

As can be seen from Table 2, the electrical performance of the solar cells with copper gridlines in Comparative Example 1 and Example 1 exhibits small differences and is nearly the same.

In conclusion, the preparation method in embodiments of the present application can simplify the photolithography process in the preparation of the copper gridlines, while not affecting the electrical performance of the solar cells.

The above are merely examples of the present application, and are not intended to limit protection scope of the present application. For those skilled in the art, various modifications and changes can be made in the present application. Any modification, equivalent substitution, improvement, etc. made within the spirit and principles of this application shall fall within the protection scope of the present application.

## Claims

1. A method for preparing a solar cell with copper gridlines, comprising following steps:
plating copper films on a first surface and a second surface of a cell sheet to be prepared with copper gridlines respectively;
printing a photoresist on a surface of the copper film on the first surface;
wrapping edges of the cell sheet with an edge-wrapping adhesive;
performing a first baking to dry the edge-wrapping adhesive and the photoresist;
printing the photoresist on a surface of the copper film on the second surface, followed by a second baking;
performing an electroplating treatment to form the copper gridlines; and
performing a film removal process.

2. The method for preparing the solar cell with the copper gridlines according to claim 1, wherein a temperature of the first baking is equal to a temperature of the second baking, and a time period of the first baking is longer than a time period of the second baking.

3. The method for preparing the solar cell with the copper gridlines according to claim 1 or 2, wherein a time period of the first baking is in a range from 7 minutes to 15 minutes, and a temperature of the first baking is in a range from 60°C to 100°C.

4. The method for preparing the solar cell with the copper gridlines according to claim 1 or 2, wherein a time period of the second baking is in a range from 7 minutes to 15 minutes, and a temperature of the second baking is in a range from 60°C to 100°C.

5. The method for preparing the solar cell with the copper gridlines according to claim 1, wherein the copper film is plated by a PVD process.

6. The method for preparing the solar cell with the copper gridlines according to claim 1, wherein a region of the copper film printed with the photoresist is a printed region, and a distance from an edge of the printed region to a side edge of the cell sheet is in a range from 0.1 mm to 0.3 mm.

7. The method for preparing the solar cell with the copper gridlines according to claim 1, wherein the electroplating treatment comprises following steps:
exposing a region of the dried photoresist corresponding to the copper gridlines to light to form an exposed region corresponding to a copper gridline pattern on the photoresist, and then performing electroplating to form copper gridlines in the exposed region.

8. The method for preparing the solar cell with the copper gridlines according to claim 1, wherein the film removal process comprises the following step: removing portions of the copper film and the photoresist that do not correspond to the copper gridlines.

9. The method for preparing the solar cell with the copper gridlines according to claim 1, wherein a thickness of the cell sheet is in a range from 0.12 mm to 0.14 mm.

10. The method for preparing the solar cell with the copper gridlines according to claim 1, wherein a thickness of the copper film is in a range from 135 nm to 155 nm.

11. The method for preparing the solar cell with the copper gridlines according to any one of claims 1, 2, and 5 to 10, wherein the step of wrapping edges of the cell sheet with the edge-wrapping adhesive comprises wrapping adhesive by using an adhesive-wrapping roller;
the adhesive-wrapping roller has a three-layer roller structure rotating coaxially with large upper and lower rollers and a small middle roller, surfaces of the three rollers jointly define a groove, and a hole is formed on a side surface of the groove to discharge the adhesive.

12. The method for preparing the solar cell with the copper gridlines according to claim 11, wherein in the three-layer roller structure, adjacent layers are sealed from each other.

13. The method for preparing the solar cell with the copper gridlines according to claim 11, wherein the upper roller and the middle roller are hollow to store the adhesive.

14. The method for preparing the solar cell with the copper gridlines according to any one of claims 1, 2, and 5 to 10, wherein the cell sheet comprises a doped silicon wafer with a PN junction and transparent conducting films located on the first surface and the second surface.

15. The method for preparing the solar cell with the copper gridlines according to claim 14, wherein the transparent conducting film is made of ITO.

16. The method for preparing the solar cell with the copper gridlines according to any one of claims 1, 2, and 5 to 10, wherein the first surface is a front surface of the cell sheet, and the second surface is a back surface of the cell sheet.

17. The method for preparing the solar cell with the copper gridlines according to any one of claims 1, 2, and 5 to 10, wherein the first surface is a back surface of the cell sheet, and the second surface is a front surface of the cell sheet.

18. A solar cell with copper gridlines prepared with the method for preparing the solar cell with the copper gridlines according to any one of claims 1 to 17.
